# EUROPEAN PATENT APPLICATION

(11) **EP 4 518 268 A1**
(43) Date of publication of application: **05.03.2025**
(21) Application number: 23838658.5
(22) Date of filing: 20.06.2023
(51) Int. Cl.: H04L 27/26

(54) **SIGNAL PROCESSING METHOD, ELECTRONIC DEVICE, AND STORAGE MEDIUM**

(30) Priority: 15.07.2022 CN 202210833076
(71) Applicant: ZTE Corporation, Shenzhen, Guangdong 518057 (CN)
(72) Inventor: XU, Xiaojing, Shenzhen, Guangdong 518057 (CN); LIN, Wei, Shenzhen, Guangdong 518057 (CN); YOU, Wei, Shenzhen, Guangdong 518057 (CN); RUI, Hua, Shenzhen, Guangdong 518057 (CN)
(74) Representative: Ziebig Hengelhaupt Intellectual Property Attorneys Patentanwaltskanzlei PartGmbB
(86) International application number: PCT/CN2023/101426
(87) International publication number: WO 2024/012164

(57) **Abstract**

The present application discloses a signal processing method, an electronic device, a storage medium, and a program product. The signal processing method comprises: when a data symbol in a signal stream is received, performing signal processing according to the data symbol and a first channel estimation value to obtain a demodulated data symbol, wherein the first channel estimation value is obtained according to a previous signal symbol of the data symbol.

## Description

### CROSS REFERENCE TO RELATED APPLICATION

The present application is based on and claims the benefit of priority from Chinese Patent Application No. 202210833076.7, filed on July 15, 2022, the entirety of which is incorporated herein by reference.

### TECHNICAL FIELD

The present application relates to the field of communication technology, and particular to a signal processing method, an electronic device, a computer storage medium, and a computer program product.

### BACKGROUND

With the increasing demand for wireless communication, the demand for wireless bandwidth also increases continuously, and various super-large bandwidths emerge accordingly, it can be foreseen that future communication systems still require larger bandwidth to meet the increasing demand for communication. With the continuous increase of wireless bandwidth, higher requirements are imposed on hardware processing capability of receivers. Currently, in the symbol-level processing of receivers, processing units typically operate at the timeslot level. This necessitates the aggregation of all symbol data within a timeslot before the symbol processing procedure can be initiated. Consequently, overall processing latency is unavoidably extended. Moreover, due to the requirement of simultaneously storing multiple data symbols across an entire timeslot, the demand for storage space is significantly increased.

### SUMMARY

Embodiments of the present application provide a signal processing method, an electronic device, a computer storage medium, and a computer program product, which can reduce signal processing delay and save storage space.

In a first aspect, an embodiment of the present application provides a signal processing method, the signal processing method comprises:
when a data symbol in a signal stream is received, signal processing is performed according to the data symbol and a first channel estimation value to obtain a demodulated data symbol, wherein the first channel estimation value is obtained according to a previous signal symbol of the data symbol.

In a second aspect, an embodiment of the present application further provides an electronic device, comprising: a memory, a processor, and a computer program stored on the memory and executable on the processor, the computer program, when executed by the processor, implements the signal processing method as described above.

In a third aspect, an embodiment of the present application further provides a computer-readable storage medium storing computer-executable instructions, wherein the computer-executable instructions are used to executes the signal processing method as described above.

In a fourth aspect, an embodiment of the present application further provides a computer program product, the computer program or the computer instruction is stored in a computer-readable storage medium, a processor of a computer device reads the computer program or the computer instruction from the computer-readable storage medium, and the processor executes the computer program or the computer instruction, so that the computer device executes the signal processing method as described above.

In an embodiment of the present application, when a data symbol in a signal stream is received, signal processing is performed according to the data symbol and a first channel estimation value to obtain a demodulated data symbol. That is, when a data symbol is received, it can be quickly processed without waiting for all the data symbols in the signal stream to be received before performing processing, thereby reducing signal processing delay. And the first channel estimation value is obtained according to a previous signal symbol of the data symbol, which indicates that the processing of the data symbol can be implemented only by combining related processed data of the previous signal symbol, therefore, only the current data symbol and data of the previous signal symbol need to be stored, thereby saving storage space, which is also beneficial to implement a pipelined processing of a signal stream, and to improve the capability of signal bandwidth processing, thereby filling in the technological gap in related methods.

### BRIEF DESCRIPTION OF DRAWINGS

FIG. 1 is a flow chart of a signal processing method provided in an embodiment of the present application;
FIG. 2 is a schematic diagram of a signal stream provided in an embodiment of the present application;
FIG. 3 is a schematic diagram of a signal stream provided in another embodiment of the present application;
FIG. 4 is a flowchart of obtaining a first channel estimation value when a signal symbol is a pilot symbol in a signal processing method provided in an embodiment of the present application;
FIG. 5 is a flowchart of obtaining a first channel estimation value when a signal symbol is a data-type symbol in a signal processing method provided in an embodiment of the present application;
FIG. 6 is a flow chart of performing channel data processing in a signal processing method provided in an embodiment of the present application;
FIG. 7 is a flow chart of obtaining a first decision result in a signal processing method provided in an embodiment of the present application;
FIG. 8 is a flow chart of obtaining a first decision result in a signal processing method provided in another embodiment of the present application;
FIG. 9 is a flow chart of obtaining a first decision result in a signal processing method provided in another embodiment of the present application;
FIG. 10 is a flow chart of obtaining a demodulated data symbol in a signal processing method provided in an embodiment of the present application;
FIG. 11 is a flow chart of performing symbol optimization on a first intermediate data symbol to obtain an equalized data symbol in a signal processing method provided in an embodiment of the present application;
FIG. 12 is a schematic diagram of the principle of an OFDM system receiver to which a signal processing method is applied that is provided in an embodiment of the present application;
FIG. 13 is a schematic diagram of a symbol-level processing module in an OFDM system receiver provided in an embodiment of the present application;
FIG. 14 is a flow chart of a signal processing method provided in another embodiment of the present application;
FIG. 15 is a schematic diagram of the principle of an OFDM system receiver to which a signal processing method is applied that is provided in another embodiment of the present application; and
FIG. 16 is a schematic diagram of an electronic device provided in an embodiment of the present application.

### DETAILED DESCRIPTION

In order to clarify the objects, technical methods and advantages of the present application, the present application will be further illustrated in detail below in conjunction with accompanying drawings and embodiments. It should be understood that the specific embodiments described herein are merely used to illustrate the present disclosure and not intended to be limiting.

It should be noted that although a logical sequence is shown in a flow chart, in some cases, the steps shown or described can be performed in a sequence different from that in the flowchart. The terms "first", "second", and the like in the description and in the claims are used to distinguish between similar objects rather than necessarily describing a specific sequence or an order.

The present application provides a signal processing method, an electronic device, a computer storage medium, and a computer program product. Wherein the signal processing method in one embodiment comprises: when a data symbol in a signal stream is received, signal processing is performed according to the data symbol and a first channel estimation value to obtain a demodulated data symbol, wherein the first channel estimation value is obtained according to a previous signal symbol of the data symbol. In this embodiment, when a data symbol in a signal stream is received, signal processing is performed according to the data symbol and a first channel estimation value to obtain a demodulated data symbol. That is, when a data symbol is received, it can be quickly processed without waiting for all the data symbols in the signal stream to be received before performing processing, thereby reducing signal processing delay. And the first channel estimation value is obtained according to a previous signal symbol of the data symbol, which indicates that the processing of the data symbol can be implemented only by combining related processed data of the previous signal symbol, therefore, only the current data symbol and data of the previous signal symbol need to be stored, thereby saving storage space, which is also beneficial to implement a pipelined processing of a signal stream, and to improve the capability of signal bandwidth processing, thereby filling in the technological gap in related methods.

Embodiments of the present application will be further described below in conjunction with the accompanying drawings.

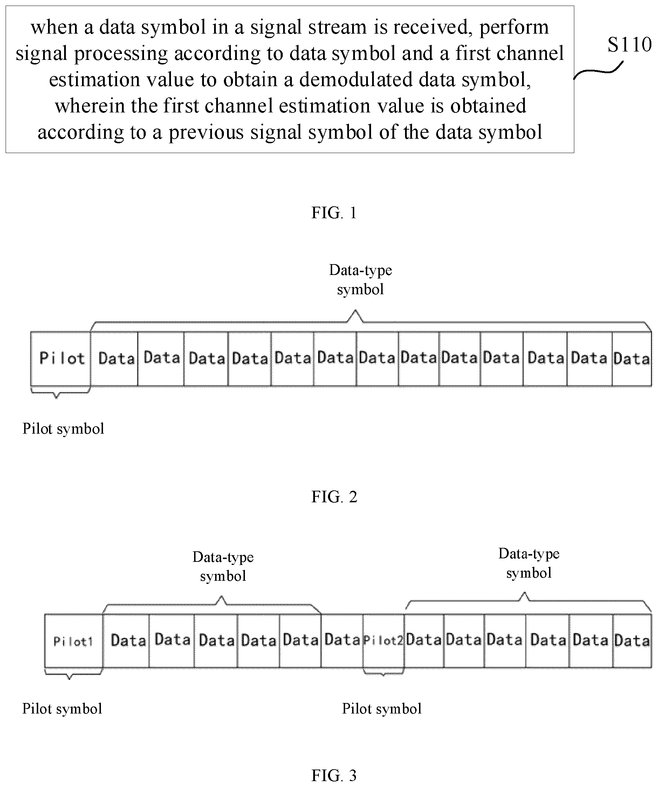

As shown in FIG. 1, FIG. 1 is a flow chart of a signal processing method provided in an embodiment of the present application, the signal processing method can comprise but is not limited to step S110.

Step S110: when a data symbol in a signal stream is received, performing signal processing according to data symbol and a first channel estimation value to obtain a demodulated data symbol, wherein the first channel estimation value is obtained according to a previous signal symbol of the data symbol.

In this step, when a data symbol in a signal stream is received, signal processing is performed according to the data symbol and a first channel estimation value to obtain a demodulated data symbol. That is, when a data symbol is received, it can be quickly processed without waiting for all the data symbols in the signal stream to be received before performing processing, thereby reducing signal processing delay. And the first channel estimation value is obtained according to a previous signal symbol of the data symbol, which indicates that the processing of the data symbol can be implemented only by combining related processed data of the previous signal symbol, therefore, only the current data symbol and data of the previous signal symbol need to be stored, thereby saving storage space, which is also beneficial to implement a pipelined processing of a signal stream, and to improve the capability of signal bandwidth processing, thereby filling in the technological gap in related methods.

In one embodiment, an execution subject of the present application is not specifically limited and can be selected according to specific application scenarios. For example, it can be a receiver, that is, the receiver performs the signal processing method in embodiments of the present application by receiving a data symbol in a signal stream; for another example, it can be a preset network model, module, etc., the network model or module has the function of receiving signals and the capability to perform related signal processing on the received signals.

In one embodiment, since step S110 is performed on each data symbol in the signal stream, a plurality of demodulated data symbols are finally obtained. That is, by performing signal processing on various data symbols and its corresponding first channel estimation value, the possible mutual influence of signals among data symbols can be effectively reduced, thereby obtaining a stable and reliable demodulation output result; and specific methods of obtaining the first channel estimation value will be gradually illustrated in the following embodiments.

In one embodiment, the embodiment of the present application can be applied to, but is not limited to, orthogonal frequency division multiplexing (OFDM) technology, for example, applied to an OFDM receiver in a MIMO system. OFDM is a type of multi carrier modulation (MCM), and is one of the implementations of a multi carrier transmission scheme. It implements parallel transmission of high-speed serial data by frequency division multiplexing, and has good multipath fading resistance and can support multi-user access. Accordingly, in embodiments of the present application, the signal stream can be, but is not limited to, an OFDM signal stream, and the data symbol is an OFDM symbol. To avoid redundancy, the following embodiments will be mainly illustrated and described based on this application scenario; however, it can be understood that those skilled in the art can also select to apply the signal processing method of embodiments of the present application according to specific application scenarios, which is not limited here. For example, a new application scenario derived along with further development of a wireless network system is not excluded.

In one embodiment, as shown in FIG. 2 and FIG. 3, the signal stream is an OFDM frequency domain signal which comprises a series of OFDM symbols, these OFDM symbols include both pilot symbols and data symbols, and the patterns of the pilot symbols and data symbols are of a plurality of kinds, reference can be made to the 3GPP 38.211 protocol, two kinds of them are shown in FIG. 2 and FIG. 3, and the difference between them is the number of pilot symbols, that is, there is only one pilot symbol in FIG. 2, whereas there are two pilot symbols in FIG. 3, both of them can be applied to embodiments of the present application; that is, by receiving a signal stream, a receiver can receive various data symbols arranged on the time domain; as for embodiments of the present application, a receiver to which embodiments of the present application are applied can receive, but is not limited to, a complete signal stream, however, whenever a data symbol in the signal stream is received, the data symbol will be processed, therefore, when the last data symbol in the signal stream is received, it is equivalent to completing processing of the signal stream, it can also be seen from this aspect that the capability of signal bandwidth processing of the receiver to which the embodiments of the present application are applied can be significantly enhanced.

**In** one embodiment, there can be a plurality of types of signal symbols, which is not limited here. For example, a signal symbol can be a pilot symbol in a signal stream that can be used to perform channel estimation, which will be gradually described in the following embodiments; for another example, a signal symbol can be a data-type symbol in a signal stream, typically all of the data-type symbols are arranged after its corresponding pilot symbols.

The two types of signal symbols mentioned above will be described separately below.

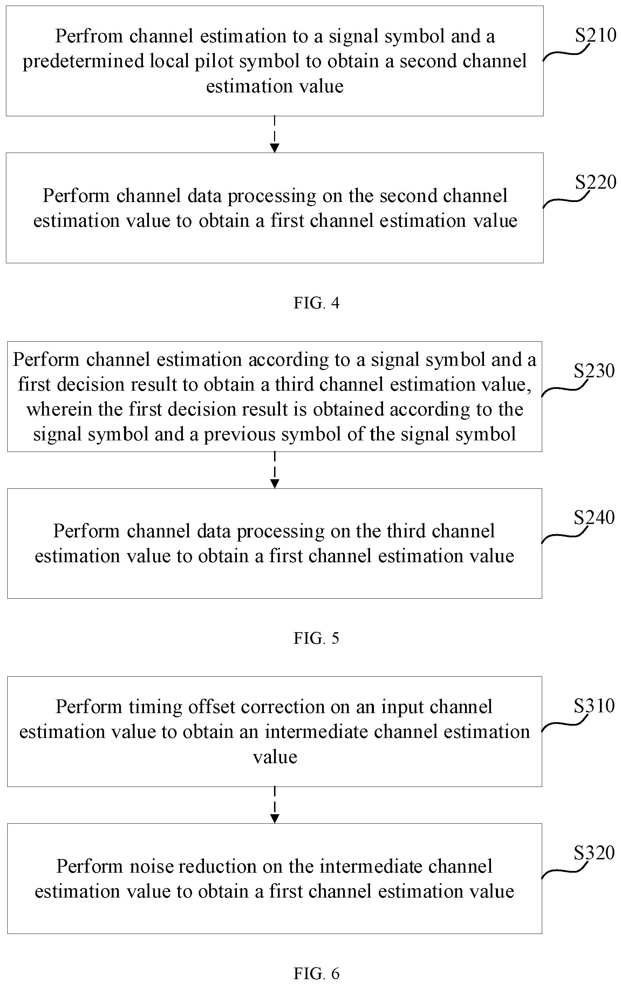

As shown in FIG. 4, in one embodiment of the present application, when a signal symbol is a pilot symbol, a first channel estimation value can be obtained by, but is not limited to, the following steps S210 and S220.

Step S210: channel estimation is performed according to a signal symbol and a predetermined local pilot symbol to obtain a second channel estimation value;
Step S220: channel data processing on the second channel estimation value is performed to obtain a first channel estimation value.

In this step, since the local pilot symbol is known in advance, when a data symbol is received, that is, when a previous signal symbol of the data symbol is determined, the channel estimation can be performed according to the signal symbol and the predetermined local pilot symbol to obtain the second channel estimation value, and the first channel estimation value can be reliably obtained by performing the channel data processing on the second channel estimation value, thereby improving the accuracy of channel estimation.

In one embodiment, since the pilot symbol can be located at, but is not limited to, the first position of a signal stream, in this case, a corresponding channel estimation value can be obtained by coordinated calculation with the local pilot symbol, that is, in the case where a signal symbol is a pilot symbol, the first channel estimation value can be accurately and reliably calculated.

In one embodiment, when there a plurality of pilot symbols in a signal stream, the first channel estimation value can be calculated and obtained for each pilot symbol with reference to the above steps S210 and S220, the working principle is the same, and the configuration of the plurality of pilot symbols can be implemented with reference to the NR 3GPP 38.211 protocol, which will not be repeated here to avoid redundancy.

In one embodiment, there can be a plurality of specific ways to perform channel estimation according to a signal symbol and a predetermined local pilot symbol, which is not limited here. For example, it can be implemented by, but is not limited to, adopting the least squares (LS) channel estimation algorithm, or it can be implemented by, but is not limited to, adopting other conventional communication algorithms commonly used in the art, wherein the least squares method is a general mathematical model widely used in data processing fields such as error estimation, uncertainty, system identification, prediction, and forecasting, which will not be repeated here.

As shown in FIG. 5, in one embodiment of the present application, when a signal symbol is a data-type symbol, the first channel estimation value can be obtained by, but is not limited to, the following steps S230 and S240.

Step S230: channel estimation is performed according to a signal symbol and a first decision result to obtain a third channel estimation value, wherein the first decision result is obtained according to the signal symbol and a previous symbol of the signal symbol;
Step S240: channel data processing is performed on the third channel estimation value to obtain a first channel estimation value.

In this step, when a signal symbol is a data-type symbol, it indicates that the signal symbol and the current data symbol belong to the same type, in this case, a third channel estimation value can be determined by obtaining the first decision result of the signal symbol and combining it with the signal symbol, and then a final first channel estimation value is obtained by performing channel data processing on the third channel estimation value, thereby improving the accuracy of channel estimation. It can be seen that since the first decision result is obtained according to the signal symbol and a previous symbol of the signal symbol, it means that the channel estimation value corresponding to the signal symbol is obtained according to the previous symbol of the signal symbol, and so on, it can also be proved in this aspect that a pipelined processing is formed for each data symbol in the signal stream.

In one embodiment, there can be a plurality of specific ways to perform channel estimation according to a signal symbol and a first decision result, which is not limited here. For example, it can be implemented by using, but is not limited to, the LS channel estimation algorithm, or it can be implemented by using, but is not limited to, other conventional communication algorithms commonly used in the art.

In one embodiment, there can be a plurality of channel data processing methods involved in steps S210 to S220 and steps S230 to S240, which is not limited here. For example, a predetermined channel data processing model can be used to calculate and process relevant channel estimation values so as to obtain a first channel estimation value; for another example, multiple channel data processing operations can be performed on related channel estimation values to obtain a first channel estimation value, etc.

Specific embodiments are given below to illustrate the process of channel data processing in detail.

As shown in FIG. 6, one embodiment of the present application further illustrates step S220 and step 240, and the "channel data processing" in step S220 and step 240 can comprise, but is not limited to, steps S310 to S320.

Step S310: timing offset correction is performed on an input channel estimation value to obtain an intermediate channel estimation value;
Step S320: noise reduction is performed on the intermediate channel estimation value to obtain a first channel estimation value.

In this step, timing offset correction is performed on an input channel estimation value to correct the time offset of the input channel estimation value, so as to obtain an intermediate channel estimation value with more accurate time offset, further, noise reduction is performed on the intermediate channel estimation value to eliminate possible interference and noise influence on the intermediate channel estimation value, thereby obtaining a processed first channel estimation value, the time offset and noise influence of the first channel estimation value are both further optimized, which can better meet the application requirements of network scenarios.

One embodiment of the present application further illustrates step S310, the step S310 can comprise, but is not limited to, step S3101.

Step S3101: timing offset estimation and timing offset compensation are performed on an input channel estimation value to obtain an intermediate channel estimation value.

In this step, by performing timing offset estimation and timing offset compensation on an input channel estimation value, the influence of time offset on the channel estimation value can be continuously optimized, that is, the size of time offset is determined by timing offset estimation, then the size of time offset is compensated correspondingly so as to obtain an intermediate channel estimation value with optimized influence of time offset, and the first channel estimation value is obtained by performing further processing on the obtained intermediate channel estimation value in the subsequent steps.

In one embodiment, timing offset estimation and timing offset compensation are technical contents well known to those skilled in the art, which will not be repeated here to avoid redundancy.

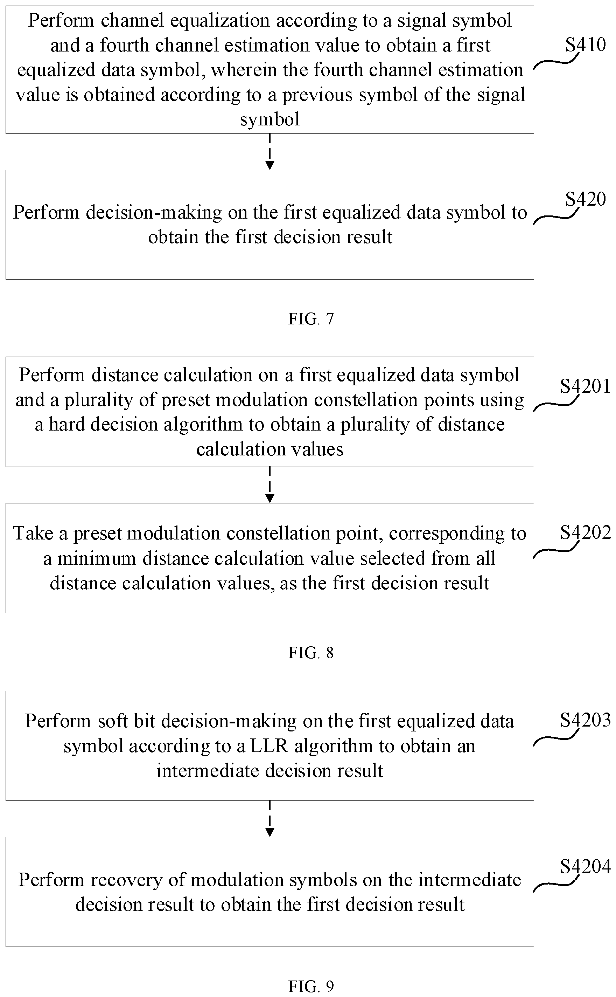

As shown in FIG. 7, one embodiment of the present application further illustrates step S230, and the "first decision result" in step S230 can be obtained by, but is not limited to, the following steps S410 to S420.

Step S410: channel equalization is performed according to a signal symbol and a fourth channel estimation value to obtain a first equalized data symbol, wherein the fourth channel estimation value is obtained according to a previous symbol of the signal symbol;
Step S420: decision-making is performed on the first equalized data symbol to obtain the first decision result.

In this step, the first equalized data symbol is obtained by performing channel equalization on the determined fourth channel estimation value and the signal symbol, so as to perform decision-making on the first equalized data symbol, thereby obtaining a first decision result, since the fourth channel estimation value is obtained according to a previous symbol of the signal symbol, it means that the first decision result finally obtained is also associated with the previous symbol of the signal symbol, which can reflect the characteristics of the embodiment of the present application for implementing pipelined processing of data symbols.

In one embodiment, the previous symbol of a signal symbol can be a pilot symbol or a data-type symbol. For example, referring to FIG. 2, when a received data symbol is the 3rd Data, the signal symbol is the 2nd Data, and the previous symbol of the signal symbol is the pilot symbol Pilot1; for another example, when a received data symbol is the 5th Data, the signal symbol is the 4th Data, and the previous symbol of the signal symbol is the 3rd Data, which is a data-type symbol.

As shown in FIG. 8, one embodiment of the present application further illustrates step S420, the step S420 comprises, but is not limited to, steps S4201 to S4202.

Step S4201: distance calculation is performed on a first equalized data symbol and a plurality of preset modulation constellation points using a hard decision algorithm to obtain a plurality of distance calculation values;
Step S4202: a preset modulation constellation point, corresponding to a minimum distance calculation value selected from all distance calculation values, is taken as the first decision result.

In this step, by further performing distance calculation on the first equalized data symbol and a preset modulation constellation point by a hard decision algorithm, a plurality of distance calculation values of the first equalized data symbol relative to a plurality of preset modulation constellation points can be obtained, and then a preset modulation constellation point corresponding to a minimum distance calculation value can be found from the plurality of distance calculation values, so as to obtain a first decision result that meets the requirements.

In one embodiment, a preset modulation constellation point can be determined by a preset communication constellation diagram, wherein the distribution diagram of signal vector endpoints is called a communication constellation diagram, which can be used to determine the bit error rate and the like of modulation methods. Specifically, in the field of digital communication, digital signals are often represented on a complex plane to visually represent signals as well as relationship among signals. The communication constellation diagram can be regarded as a "two-dimensional eye diagram" array of digital signals, and the position of modulation constellation points in the diagram has a reasonable limit or decision boundary. The graphics in the communication constellation diagram correspond to amplitude and phase, which has certain effect on the processing of identifying modulation problems such as amplitude imbalance, orthogonal error, correlated interference, phase, amplitude noise, phase error, and modulation error ratio; since those skilled in the art are familiar with the specific contents of the communication constellation diagram and modulation constellation points, they will not be repeated here.

As shown in FIG. 9, one embodiment of the present application further illustrates step S420, the step S420 comprises, but is not limited to, steps S4203 to S4204.

Step S4203: soft bit decision-making is performed on the first equalized data symbol according to a log-likelihood ratio (LLR) algorithm to obtain an intermediate decision result;
Step S4204: recovery of modulation symbols is performed on the intermediate decision result to obtain the first decision result.

In this step, soft bit decision-making is performed on the first equalized data symbol by the LLR algorithm, further, an intermediate decision result for the first equalized data symbol can be obtained, and then by performing recovery of modulation symbols on the intermediate decision result, an output symbol that meets the requirements can be obtained, that is, a first decision result that meets the requirements is obtained. In other words, the first decision result can also be accurately and reliably obtained by soft bit decision-making.

In one embodiment, in addition to the well-known LLR algorithm, other related algorithms can also be used to perform soft bit decision-making, which is not limited here.

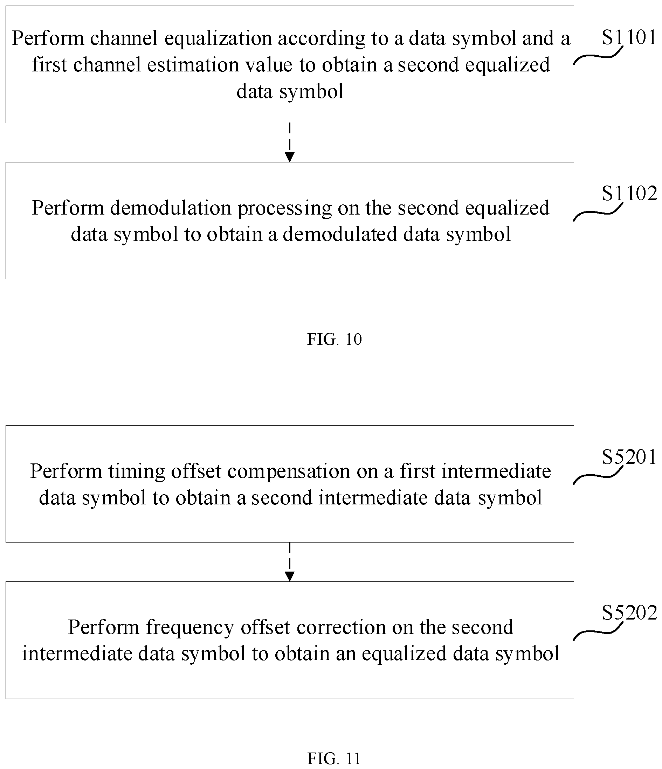

As shown in FIG. 10, one embodiment of the present application further illustrates step S110, the step S110 comprises, but is not limited to, steps S1101 to S1102.

Step S1101: channel equalization is performed according to a data symbol and a first channel estimation value to obtain a second equalized data symbol;
Step S1102: demodulation processing is performed on the second equalized data symbol to obtain a demodulated data symbol.

In this step, a second equalized data symbol is obtained after performing channel equalization on a data symbol, further, a demodulated data symbol is obtained by performing demodulation processing on the second equalized data symbol. Since the second equalized data symbol is channel-equalized, on this basis, it can be ensured that the demodulated data symbol finally obtained by conversion is more stable and reliable.

One embodiment of the present application further illustrates step S1102, the step S1102 comprises, but is not limited to, step S11021.

Step S11021: soft bit calculation is performed on the second equalizer data symbol using a LLR algorithm based on maximum a posteriori probability criterion to obtain a demodulated data symbol.

In this step, soft bit calculation is performed on the second equalized data symbol by using the LLR algorithm of the maximum a posteriori probability criterion, so that soft bit decoding of the second equalized data symbol can be achieved, thereby obtaining a demodulated data symbol that meets the requirements.

In one embodiment, there can be a plurality of kinds of soft bit calculations, such as, but are not limited to, recursive calculation, coding calculation, etc., which is well known to those skilled in the art and will not be repeated here.

In addition to steps S1101 to S1102, an embodiment of the present application can also comprise, but is not limited to, step S120.

Step S120: decision-making is performed on the second equalized data symbol to obtain a second decision result, wherein the second decision result is used to perform signal processing in conjunction with the next signal symbol of the data symbol to obtain a demodulated data symbol.

In this step, while performing demodulation processing by means of the second equalized data symbol to obtain a demodulated data symbol, decision-making can also be performed on the second equalized data symbol to obtain a second decision result, so that the obtained second decision result can be provided to the next signal symbol of the data symbol for use, therefore, reprocessing can be performed by the next signal symbol of the data symbol according to the second decision result in order to obtain a demodulated data symbol, that is, demodulated data symbols can be continuously generated in a pipelined manner by analogy.

In one embodiment, specific implementations of channel equalization and demodulation processing can be selected according to actual application scenarios, which is not limited here, the channel equalization and demodulation processing in the above embodiments are further described below.

One embodiment of the present application further illustrates step S410 and step S111, and the "channel equalization" in step S410 and step S111 can be obtained, but is not limited to, the following steps S510 to S520.

Step S510: equalization processing is performed on an input symbol and a channel estimation value using an equalizer to obtain a first intermediate data symbol;
Step S520: symbol optimization is performed on the first intermediate data symbol to obtain an equalized data symbol.

In this step, an input symbol and a channel estimation value are equalized using a preset equalizer to obtain a first intermediate data symbol, further, by performing symbol optimization on the first intermediate data symbol, an optimized equalized data symbol can be obtained, thereby achieving equalization of the input symbol.

In one embodiment, there can be a plurality of types of equalizers, which is not limited here. For example, it can be an equalizer based on a minimum mean square error (MMSE) algorithm, or it can also be an equalizer based on an interference rejection combining (IRC) algorithm, etc., wherein the IRC algorithm is an interference suppression algorithm that can improve signal reception quality in a communication system and reduce the generation of bit errors, thereby at least improving the uplink service quality.

In one embodiment, specific implementations of symbol optimization can be selected according to actual application scenarios to obtain required equalized data symbols, which are not limited here, one specific implementation is given below to illustrate the principle.

As shown in FIG. 11, one embodiment of the present application further illustrates step S520, the step S520 comprises, but is not limited to, steps S5201 to S5202.

Step S5201: timing offset compensation is performed on a first intermediate data symbol to obtain a second intermediate data symbol;
Step S5202: frequency offset correction is performed on the second intermediate data symbol to obtain an equalized data symbol.

In this step, by performing timing offset compensation on a first intermediate data symbol so as to correct timing offset errors on the first intermediate data symbol, a second intermediate data symbol is obtained, and then performing frequency offset correction on the second intermediate data symbol, correction of the residual frequency offset of the second intermediate data symbol is achieved, thereby obtaining an equalized data symbol that meets the requirements.

In one embodiment, there can be a plurality of specific ways to perform frequency offset correction on the second intermediate data symbol. For example, frequency offset correction can be implemented by using a separate operation which can be frequency offset compensation; or the frequency offset correction can be performed by a combination of operations which can be frequency offset compensation after performing frequency offset estimation, that is, frequency offset estimation and frequency offset compensation are performed on the second intermediate data symbol to obtain an equalized data symbol, in this way, the residual frequency offset on the second intermediate data symbol can be corrected.

Specific examples are given below to illustrate the working principle and process of the above embodiments.

### Example 1:

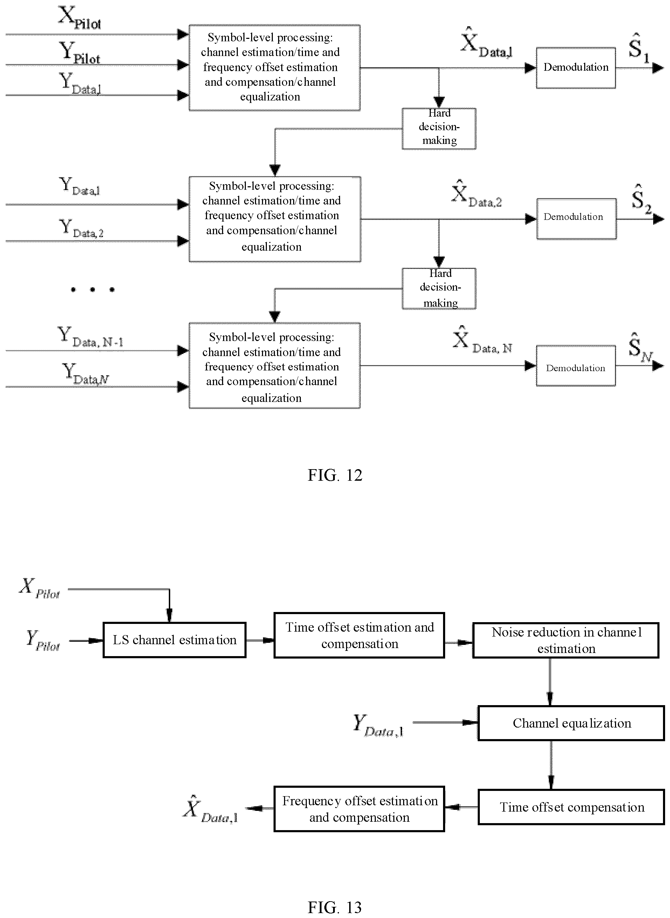

As shown in FIG. 12, FIG. 12 is a schematic diagram of the principle of an OFDM system receiver to which a signal processing method is applied that is provided in an embodiment of the present application.

Based on the signal stream shown in FIG. 2, that is, taking the OFDM system receiver that inputs the signal stream shown in FIG. 2 as an example, in the OFDM system receiver, the received frequency domain signal is represented by Y, *Y_{Pilot}* represents the received pilot symbol, the local pilot symbol of the receiving end is *X_{Pilot},* and the first symbol shown in FIG. 2 is the received pilot symbol; *Y_{Data}* represents the received data symbol, there are N = 13 data symbols in FIG. 2 that are arranged after the first pilot symbol.

In terms of symbol-level processing, the receiver performs OFDM signal detection in a pipelined processing manner, as shown in FIG. 12, the OFDM signal detection is performed according to the following steps:
Step 1: after receiving the first pilot symbol *Y_{Pilot}* and the first data symbol *Y*_{*Data*,1} by the receiver, they are input into a symbol-level processing module together with a local pilot symbol of the receiving end *X*_{*Pilo*t}, and the symbol-level processing module is used to perform symbol-level processing, the specific processing procedure is shown in FIG. 13.

Referring to FIG. 13, channel estimation is performed on the first pilot symbol *Y_{Pilot}* and the local pilot symbol of the receiving end *Y*_{*Data*,1} together.

Firstly, the LS channel estimation algorithm is used to perform channel estimation, then an algorithm related to frequency domain is used to estimate time offset and to perform time offset compensation on the pilot symbol, further, noise reduction in time domain is performed on the channel estimation value that has been compensated for time offset, thereby obtaining a channel estimation value *Ĥ*₁ on the pilot symbol. Channel equalization processing is performed both on the channel estimation result *Ĥ*₁ and the first data symbol *Y*_{*Data*,1}, the channel equalization algorithm uses the MMSE equalizer algorithm based on maximum ratio combining, then the time offset compensation is performed on the equalized data, and then frequency offset estimation and compensation is performed so as to correct residual frequency offset on the data, and finally the data *X̂*_{*Data,*1} is obtained.

Step 2: after the processing in step 1, the equalized data of the first data symbol *X̂*_{*Data,*1} is obtained, subsequent processing on the data is divided into two directions. On the one hand, it is input into the demodulation module for demodulation to obtain a demodulation result of the first data symbol *Ŝ*₁; on the other hand, it is input into the hard decision-making module for hard decision-making (i.e., the hard decision-making shown in FIG. 12), wherein the demodulation algorithm adopts the LLR algorithm based on the maximum a posteriori probability criterion to calculate the soft bit information of the modulated signal, and the hard decision algorithm is used to perform distance calculation on the equalized data and an ideal modulation constellation point, and the closest ideal constellation point is selected as the hard decision result.

Step 3: in the next processing flow, a hard decision result (which can be regarded as a local pilot symbol) and a first data symbol (which can be regarded as a received pilot symbol) as well as a second data symbol are together input into the symbol-level processing module to sequentially obtain a channel estimation result *Ĥ*₂ on the second data symbol *Y*_{*Data*,2} then the channel equalization and equalization post-processing are performed both on the channel estimation result *Ĥ*₂ and the second data symbol *Y*_{*Data*,2} to obtain an equalized result, further, the equalized result of the second data symbol *X̂*_{*Data*,2} is input into the demodulation module and the hard decision-making module for corresponding processing.

Step 4: the processing flow of subsequent data symbols is similar to that in the above step 3, which is repeated until the demodulation result of the last data symbol is obtained, thereby finally obtaining the demodulated data symbols corresponding to all data symbols.

It can be seen from the above examples that the pipelined signal processing method of embodiments of the present application can perform processing immediately after receiving a data symbol without waiting, thereby reducing the processing delay of a receiver, and only the data of a previous data symbol and the current data symbol need to be stored, which reduces the pressure on the storage space of the receiver, thereby improving the capability of frequency domain broadband processing of the receiver; moreover, the number of pilot symbols can also be reduced, and only one pre-posed pilot symbol needs to be used in a high-speed movement scenario, the channel estimation on subsequent data symbols ensures real-time tracking of channel changes, so that the system throughput can be improved.

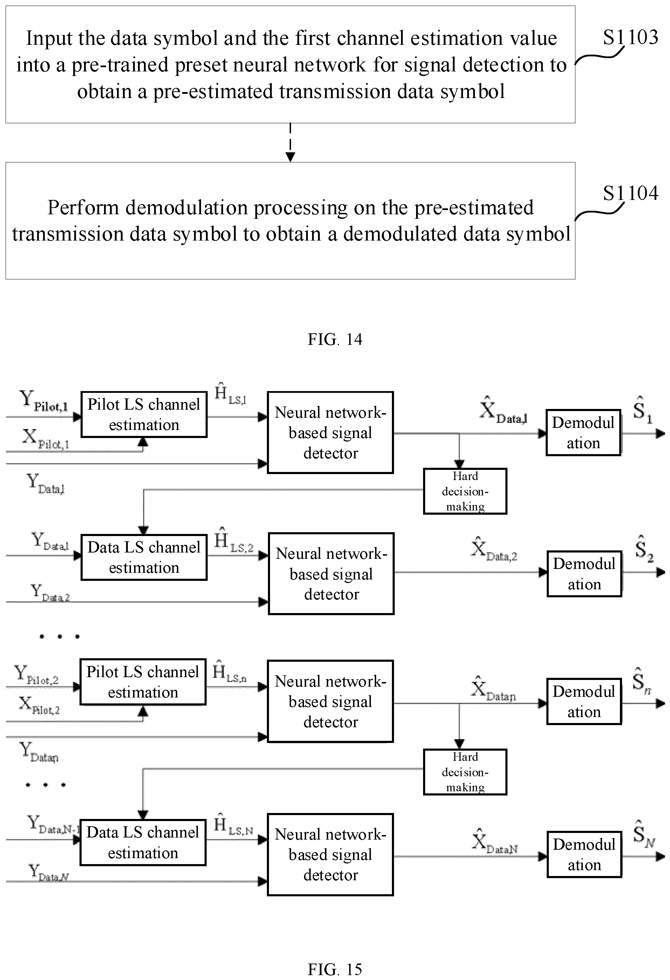

As shown in FIG. 14, one embodiment of the present application further illustrates step S110, the step S110 comprises, but is not limited to, steps S1103 to S1104.

Step S1103: the data symbol and the first channel estimation value are input into a pre-trained preset neural network for signal detection to obtain a pre-estimated transmission data symbol;
Step S1104: demodulation processing is perfromed on the pre-estimated transmission data symbol to obtain a demodulated data symbol.

In this step, a pre-trained preset neural network is used for signal detection in place of the functions such as noise reduction of channel estimation value function, time offset compensation, frequency offset compensation and signal equalization function in the aforementioned embodiments, so that an estimated transmission data symbol can be obtained, and the estimated transmission data symbol is further demodulated to obtain a demodulated data symbol, that is, the final signal demodulation processing can also be implemented by means of neural network detection. For the specific principle of performing signal detection by a preset neural network, reference can be made to functional principles such as noise reduction of channel estimation value function, time offset compensation, frequency offset compensation, and signal equalization in the aforementioned embodiments, since the principle of these functions has been described in detail, it will not be repeated here.

In one embodiment, for the preset neural network, a residual convolutional neural network can be used for modeling, which is not limited here. After the model is trained offline, signal detection can be performed online, or those skilled in the art can select a corresponding neural network according to a specific application scenario.

One embodiment of the present application further illustrates step S1104, the step S1104 comprises, but is not limited to, step S11041.

Step S11041: soft bit calculation is performed on a pre-estimated transmission data symbol using a LLR algorithm based on maximum a posteriori probability criterion to obtain a demodulated data symbol.

In this step, soft bit calculation is performed on a pre-estimated transmission data symbol by a LLR algorithm based on maximum a posteriori probability criterion, so that soft bit decoding of the estimated transmission data symbol can be implemented, thereby obtaining a demodulated data symbol that meets the requirements.

In one embodiment, there can be a plurality of kinds of soft bit calculations, for example but are not limited to, recursive calculation, coding calculation, etc., which is well known to those skilled in the art and will not be repeated here.

Specific examples are given below to illustrate the working principle and process of the above embodiments.

### Example 2:

As shown in FIG. 15, FIG. 15 is a schematic diagram of the principle of an OFDM system receiver to which a signal processing method is applied that is provided in another embodiment of the present application.

Based on the signal stream shown in FIG. 3, that is, taking the OFDM system receiver that inputs the signal stream shown in FIG. 3 as an example, in the OFDM system receiver, the received frequency domain signal is represented by Y, *Y_{Pilot}* represents the received pilot symbol, which occupies the 1st and 8th data symbols in FIG. 3, the local pilot symbol of the receiving end is *X_{Pilot}*; *Y_{Data}* represents the received data symbol, which occupies the remaining N = 12 data symbols.

In terms of symbol-level processing, the receiver performs OFDM signal detection in a pipelined processing manner, as shown in FIG. 15, the OFDM signal detection is performed according to the following steps:
Step 1: the receiver receives the first pilot symbol *Y*_{*Pilot*,1} and the local pilot of the receiving end *X*_{*Pilot*,1}, and sends both of them to the pilot LS channel estimation module to obtain a LS channel estimation value *Ĥ*_{*LS,*1}*,* which is then input into the neural network-based signal detector together with the first data symbol *Y*_{*Data*,1} to obtain the transmitted data estimation value of the first data symbol *X̂*_{*Data,*1}*,* the neural network-based signal detector here replaces traditional functions such as noise reduction of channel estimation value function, time offset compensation, frequency offset compensation, and signal equalization, and a residual convolutional neural network is used for modeling, after offline model training, the OFDM signal detection can be performed online.
Step 2: after the processing in step 1, the equalized data of the first data symbol *X̂*_{*Data,*1} is obtained, the subsequent processing of the data is divided into two directions. On the one hand, it is input into the demodulation module for demodulation processing to obtain the demodulation result of the first data symbol *Ŝ*₁; on the other hand, it is input into the hard decision-making module for hard decision-making, wherein the demodulation algorithm adopts the LLR algorithm based on the maximum a posteriori probability criterion to calculate the soft bit information of the modulated signal, and the hard decision algorithm is used to perform distance calculation on the equalized data and an ideal modulation constellation point, and the closest ideal constellation point is selected as the hard decision result.
Step 3: in the next processing flow, a hard decision result (which can be regarded as a local pilot symbol) and a first data symbol (which can be regarded as a received pilot symbol) are both input into the data LS channel estimation module to obtain a LS channel estimation result *Ĥ_{LS,2},* then the LS channel estimation result *Ĥ_{LS,2}* and the second data symbol *Y_{Data,2}* are input into the neural network-based signal detector to obtain the transmitted data estimation value *X̂*_{*Data*,2*,*} further, the transmitted data estimation value of the second data symbol *X*_{*Data,*2} is input into the demodulation module and the hard decision-making module for corresponding processing.
Step 4: the processing flow of subsequent data symbols is similar to that in the above step 3, which is repeated until the demodulation result *Ŝ*₆ of the 6th data symbol is obtained.
Step 5: after obtaining the second pilot symbol *Y*_{*Pilot*,2} and the local pilot of the receiving end *X*_{*Pilot*,2}*,* they are sent to the pilot LS channel estimation module together to obtain a LS channel estimation value at this moment, which is then input into the neural network-based signal detector together with the 7th data symbol to obtain the transmitted data estimation value of the 7th data symbol, further, the transmitted data estimation value is input into the demodulation module and the hard decision-making module for corresponding processing.
Step 6: the processing flow of subsequent data symbols is similar to that in the above step 5, which is repeated until the demodulation result of the last data symbol is obtained, thereby finally obtaining the demodulated data symbols corresponding to all data symbols.

It can be seen from the above examples that the pipelined signal processing method of embodiments of the present application can perform processing immediately after receiving a data symbol without waiting, thereby reducing the processing delay of a receiver, and only the data of a previous data symbol and the current data symbol need to be stored, which reduces the pressure on the storage space of the receiver, thereby improving the capability of frequency domain broadband processing of the receiver; moreover, the same applies even there are a plurality of pilot symbols, the channel estimation on subsequent data symbols ensures real-time tracking of channel changes, so that the system throughput can be improved.

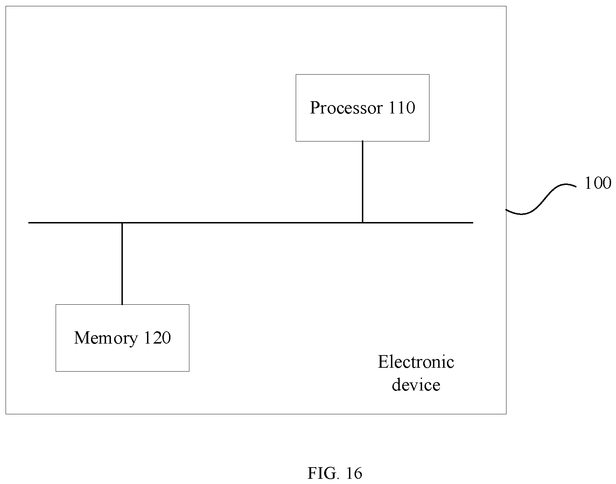

In addition, as shown in FIG. 16, an embodiment of the present application further discloses an electronic device 100, comprising: at least one processor 110; at least one memory 120 for storing at least one program; the at least one program, when executed by the at least one processor 110, implements the signal processing method in any of the previous embodiments.

In addition, an embodiment of the present application further discloses a computer-readable storage medium, in which computer-executable instructions are stored, the computer-executable instructions are used to execute the signal processing method in any of the previous embodiments.

In addition, an embodiment of the present application further discloses a computer program product, comprising a computer program or computer instruction, the computer program or computer instruction is stored in a computer-readable storage medium, a processor of a computer device reads the computer program or the computer instruction from the computer-readable storage medium, and the processor executes the computer program or the computer instruction, so that the computer device executes the signal processing method in any of the previous embodiments.

It will be appreciated by those skilled in the art that all or some of the steps and systems in the methods disclosed above can be implemented as software, firmware, hardware, and appropriate combinations thereof. Some or all physical components can be implemented as a software executed by a processor such as a central processing unit, a digital signal processor, or a microprocessor, or as a hardware, or as an integrated circuit such as an application-specific integrated circuit. Such software can be distributed on a computer-readable medium, which can include a computer storage medium (or non-transitory medium) and a communication medium (or transient medium). As known to those skilled in the art, the term "computer storage medium" includes volatile and non-volatile, removable and non-removable media implemented in any method or technology for storing information (such as computer-readable instructions, data structures, program modules, or other data). Computer storage media include, but are not limited to, RAM, ROM, EEPROM, flash memory or other memory technology, CD-ROM, digital versatile disk (DVD) or other optical disk storage, magnetic cassettes, magnetic tape, disk storage or other magnetic storage devices, or any other medium that can be used to store desired information and can be accessed by a computer. Furthermore, it is well known to those skilled in the art that communication media generally comprise computer readable instructions, data structures, program modules, or other data in a modulated data signal such as a carrier wave or other transport mechanism, and can include any information delivery media.

## Claims

1. A signal processing method, comprising:
when a data symbol in a signal stream is received, performing signal processing according to the data symbol and a first channel estimation value to obtain a demodulated data symbol, wherein the first channel estimation value is obtained according to a previous signal symbol of the data symbol.

2. The signal processing method according to claim 1, wherein the signal symbol is a data-type symbol or a pilot symbol.

3. The signal processing method according to claim 2, wherein when the signal symbol is a pilot symbol, the first channel estimation value is obtained by the following steps:
performing channel estimation according to the signal symbol and a predetermined local pilot symbol to obtain a second channel estimation value; and
performing channel data processing on the second channel estimation value to obtain the first channel estimation value.

4. The signal processing method according to claim 2, wherein when the signal symbol is a data-type symbol, the first channel estimation value is obtained by the following steps:
performing channel estimation according to the signal symbol and a first decision result to obtain a third channel estimation value, wherein the first decision result is obtained according to the signal symbol and a previous symbol of the signal symbol; and
performing channel data processing on the third channel estimation value to obtain the first channel estimation value.

5. The signal processing method according to claim 3 or 4, wherein the channel data processing comprises:
performing timing offset correction on an input channel estimation value to obtain an intermediate channel estimation value; and
performing noise reduction on the intermediate channel estimation value to obtain the first channel estimation value.

6. The signal processing method according to claim 5, wherein performing timing offset correction on an input channel estimation value to obtain an intermediate channel estimation value comprises:
performing timing offset estimation and timing offset compensation on an input channel estimation value to obtain an intermediate channel estimation value.

7. The signal processing method according to claim 4, wherein first decision result is obtained by the following steps:
performing channel equalization according to the signal symbol and a fourth channel estimation value to obtain a first equalized data symbol, wherein the fourth channel estimation value is obtained according to a previous symbol of the signal symbol; and
performing decision-making according to the first equalized data symbol to obtain the first decision result.

8. The signal processing method according to claim 7, wherein performing decision-making according to the first equalized data symbol to obtain the first decision result comprises:
performing distance calculation on the first equalized data symbol and a plurality of preset modulation constellation points using a hard decision algorithm to obtain a plurality of distance calculation values; and
taking a preset modulation constellation point, corresponding to a minimum distance calculation value selected from all the distance calculation values, as the first decision result.

9. The signal processing method according to claim 7, wherein performing decision-making according to the first equalized data symbol to obtain the first decision result comprises:
performing soft bit decision-making on the first equalized data symbol according to a log-likelihood ratio LLR algorithm to obtain an intermediate decision result; and
performing recovery of modulation symbols on the intermediate decision result to obtain the first decision result.

10. The signal processing method according to claim 1, wherein performing signal processing according to the data symbol and a first channel estimation value to obtain a demodulated data symbol comprises:
performing channel equalization according to the data symbol and a first channel estimation value to obtain a second equalized data symbol; and
performing demodulation processing on the second equalized data symbol to obtain a demodulated data symbol.

11. The signal processing method according to claim 7 or 10, wherein the channel equalization comprises:
performing equalization processing on an input symbol and a channel estimation value using an equalizer to obtain a first intermediate data symbol; and
performing symbol optimization on the first intermediate data symbol to obtain an equalized data symbol.

12. The signal processing method according to claim 11, wherein performing symbol optimization on the first intermediate data symbol to obtain an equalized data symbol comprises:
performing timing offset compensation on the first intermediate data symbol to obtain a second intermediate data symbol; and
performing frequency offset correction on the second intermediate data symbol to obtain an equalized data symbol.

13. The signal processing method according to claim 12, wherein performing frequency offset correction on the second intermediate data symbol to obtain an equalized data symbol comprises:
performing frequency offset estimation and frequency offset compensation on the second intermediate data symbol to obtain an equalized data symbol.

14. The signal processing method according to claim 1, wherein performing signal processing according to the data symbol and a first channel estimation value to obtain a demodulated data symbol comprises:
inputting the data symbol and the first channel estimation value into a pre-trained preset neural network for signal detection to obtain a pre-estimated transmission data symbol; and
performing demodulation processing on the pre-estimated transmission data symbol to obtain a demodulated data symbol.

15. The signal processing method according to claim 10 or 14, wherein the demodulation processing comprises:
performing soft bit calculation on an input data symbol using a LLR algorithm based on maximum a posteriori probability criterion to obtain a demodulated data symbol.

16. The signal processing method according to claim 10, wherein the signal processing method further comprises:
performing decision-making according to the second equalized data symbol to obtain a second decision result, wherein the second decision result is used to perform signal processing in conjunction with a next signal symbol of the data symbol to obtain a demodulated data symbol.

17. The signal processing method according to claim 4, wherein performing channel estimation according to the signal symbol and a first decision result to obtain a third channel estimation value comprises:
performing channel estimation on the signal symbol and a first decision result using a least squares LS channel estimation algorithm to obtain a third channel estimation value.

18. The signal processing method according to claim 3, wherein performing channel estimation according to the signal symbol and a predetermined local pilot symbol to obtain a second channel estimation value comprises:
performing channel estimation on the signal symbol and a predetermined local pilot symbol using a LS channel estimation algorithm to obtain a second channel estimation value.

19. An electronic device, comprising:
at least one processor; and
at least one memory for storing at least one program;
wherein the at least one programs, when executed by the at least one processor, implements the signal processing method according to any one of claims 1 to 18.

20. A computer-readable storage medium, storing a processor-executable computer program thereon, wherein the processor-executable computer program, when executed by a processor, implements the signal processing method according to any one of claims 1 to 18.

21. A computer program product, comprising a computer program or computer instruction, wherein the computer program or the computer instruction is stored in a computer-readable storage medium, a processor of a computer device reads the computer program or the computer instruction from the computer-readable storage medium, and the processor executes the computer program or the computer instruction, so that the computer device executes the signal processing method according to any one of claims 1 to 18.
